# EUROPEAN PATENT APPLICATION

(11) **EP 1 523 018 A2**
(43) Date of publication of application: **13.04.2005**
(21) Application number: 04017987.1
(22) Date of filing: 29.07.2004
(51) Int. Cl.: H01F 27/28, H01F 41/04

(54) **Small coil and method of manufacturing the same**

(30) Priority: 06.10.2003 JP 2003346953
(71) Applicant: Goto Denshi Co., Ltd., Sagae-shi, Yamagata 991-0063 (JP)
(72) Inventor: Goto, Yoshihide Goto Denshi Co., Ltd., Sagae-shi Yamagata 991-0063 (JP); Oonuma, Katuyosi Goto Denshi Co., Ltd., Sagae-shi Yamagata 991-0063 (JP)
(74) Representative: Grünecker, Kinkeldey, Stockmair & Schwanhäusser Anwaltssozietät

(57) **Abstract**

A conductive material and an insulating material are injected from two injection ports (7,8) of an ink jet technique to form a pattern of a coil by stacking arbitrary number of a conductive layer (5) and an insulating layer (6) alternately. By forming an exposed part (13c,17c) on which the insulating layer is not formed, conductive layer turns of the respective layers (3,4) are connected. An in-lead (9) and an out-lead (10) are connected to the respective layers (3,4).

## Description

### BACKGROUND OF THE INVENTION

### 1.Field of the Invention

The present invention relates to a small coil to be assembled in a circuit pattern, and a method of manufacturing the same.

### 2.Description of the Related Art

A conventional small coil is formed by winding a wire having a predetermined diameter around a bobbin. The smaller the coil is, the smaller the diameter of the wire becomes.

Accordingly, the strength of the wire decreases, and if the wire is cut at the time of winding, after the wire is connected, the winding process has to be further performed. Consequently, reduction in the size of the coil is limited.

There is another method of manufacturing a coil by printing copper foil or the like on a film, etching an unnecessary portion to form an arbitrary conductive pattern, and stacking films with patterns (print pattern method). In such a method as well, reduction in the size of the coil is limited by precision of etching and the thickness of a film. As prior art, there is Japanese Patent Application Laid-open Publication No. 59-2311.

In the coil obtained by the above method of mechanically winding a fine wire around a bobbin, the coil obtained by the above method of forming a pattern by the print pattern method, and the like, reduction in the size of the coil is limited. Consequently, an inexpensive and very small coil, and a method of manufacturing the same requiring no expensive manufacturing facility are expected.

### Summary of the Invention

The invention according to claim 1 relates to a small coil comprising:
a first conductive layer formed as a first turn of a coil by injecting a fine conductive material onto a substrate;
a first insulating layer made of an insulating material injected onto the first conductive layer while a part of the first conductive layer is exposed; and
a second conductive layer similarly formed as a second turn of the coil on the first insulating layer,
wherein said second conductive layer is connected to the exposed part of said first conductive layer and, in such a manner, conductive layers and insulating layers are sequentially alternately stacked.

It is preferable that the exposed part of said first conductive layer is formed at a front end of said first conductive layer, and is connected to a base end of said second conductive layer, and said conductive layer may have a cylindrical shape or a prism shape.

The invention according to claim 4 relates to a method of manufacturing a small coil, comprising the processes of:
forming a first conductive layer as a first turn of a coil by injecting mixed ink obtained by mixing a fine conductive material from an injection nozzle to a solvent onto a substrate;
forming an insulating layer by injecting mixed ink obtained by mixing an insulating material to a solvent onto the first conductive layer in a state where a part of the first conductive layer is exposed;
forming a second conductive layer as a second turn of the coil on the insulating layer; and
sequentially alternately stacking conductive layer patterns and insulating layers while connecting the exposed part of the first conductive layer and the second conductive layer to each other.

It is preferable that the exposed part of said first conductive layer is formed at a front end of said first conductive layer, and is connected to a base end of said second.conductive layer.

Further, it is preferable that said injection nozzle is an inj ection nozzle used for an ink jet printing method.

With the configuration mentioned above, a coil much smaller than a coil formed by the conventional winding method or print pattern method can be manufactured. A hyperfine ink jet technique used as an ink jet technique is a resource-saving, energy-saving, and environment-adapted technique, and does not require an expensive manufacturing facility as used in a semiconductor process, and can perform hyperfine fabrication in the atmosphere and, moreover, on a desktop. Thus, a facility load can be largely reduced. Further, an exposure mask, an evaporation mask or the like is unnecessary, so that time from circuit designing to prototyping can be largely shortened. Dramatic improvements in development speed as well as reduction in manufacture time can be expected. An effect such that an inexpensive and very-small coil can be effectively provided is produced.

### BRIEF DESCRIPITON OF THE DRAWINGS

FIG. 1 is a cross sectional view of a small coil according to the invention;
FIG. 2 shows a state where a first turn of a first layer having an in-lead is formed;
FIG. 3 is a diagram showing a state where a circular insulating layer for a first turn of a second layer is formed on the outside of the first turn of FIG. 2;
FIG. 4 is a diagram showing a state where the first turn of the second layer having an out-lead is formed on the circular insulating layer of FIG. 3;
FIG. 5 is a diagram showing a state of a connection portion of the turns in the first and second layers;
FIG. 6 is a cross sectional view taken along line A-A of FIG.5;
FIG. 7 is a diagram showing a connection state of arbitrary turns in the first and second layers;
FIG. 8 is a diagram showing a state where conductive layers of N-th turns in each layer are formed;
FIG. 9 is a diagram showing a state where an insulating layer for the "N+1"th turn of each layer is formed;
FIG. 10 is a diagram showing a state where a conductive layer for the "N+1"th turn of each layer is formed;
FIG 11 is a diagram showing a state where an insulating layer for the "N+2"th turn of each layer is formed; and
FIG. 12 is a diagram showing a state in which an intermediate portion of each layer is filled with an insulating material.

### DESCRIPTION OF THE PREFERRED EMBODIMENTS

In the invention, attention is paid to the hyperfine ink jet technique of injecting ink to a paper and the technique is applied. The ink jet printing technique is inherently a technique of injecting ink extremely precisely. Materials used for inks of the ink jet technique are classified roughly into "coloring material" , "solvent", and "subsidiary material". In place of the coloring material, metallic particles having excellent conductivity, generally, metallic particles called a nano-paste having a diameter less than 10 nanometers are used. An ink obtained by mixing the metallic particles with a solvent, a subsidiary material, and the like, is injected so as to be applied to a width of 10 µm or less on a predetermined substrate or the like, thereby forming a fine conductive pattern. As an insulating layer which is important to construct a coil, a fine insulating layer having strength which is sufficient in practical use is also obtained by injecting an ink obtained by mixing an excellent insulating material (such as resin) in place of the coloring materialwithsolvent,subsidiary material, and the like so as to be applied on the surface of the layer by using the hyperfine ink jet technique.

An embodiment of the invention will be described below with reference to the drawings.

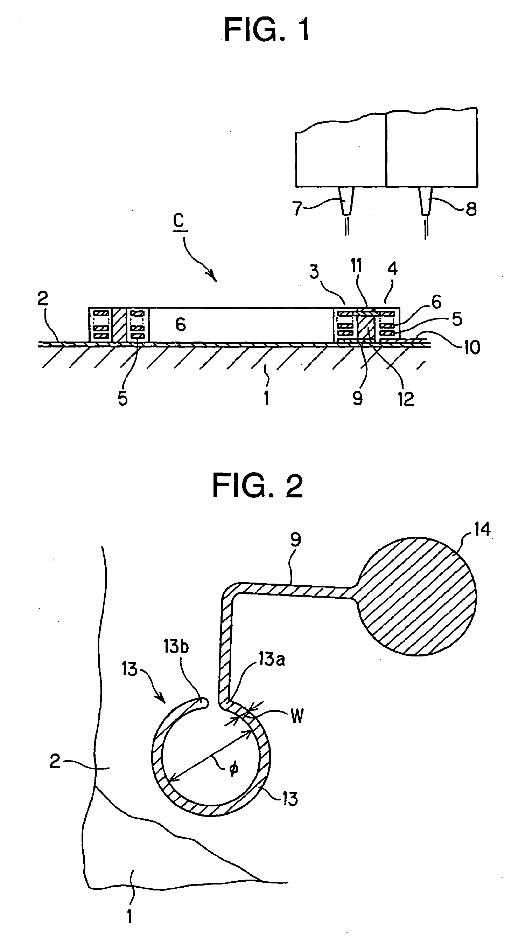

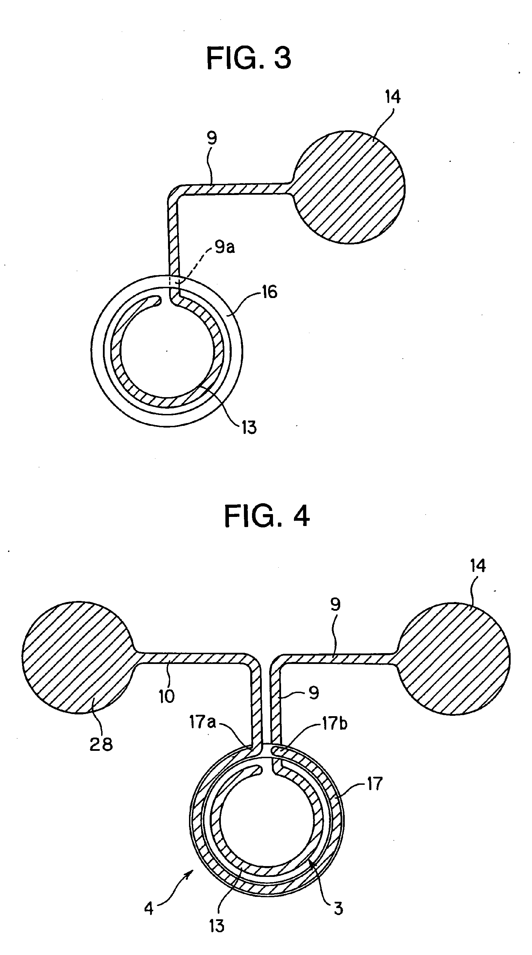

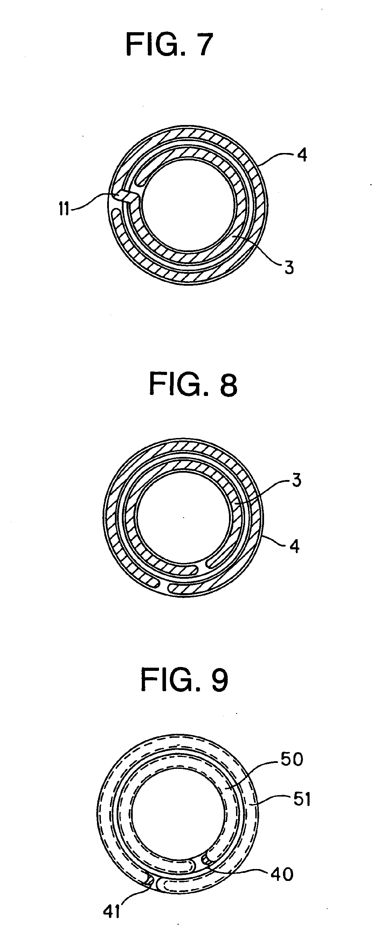

FIG. 1 is a cross sectional view of a small coil C of two layers formed on a substrate 1. On the substrate 1, an insulating film 2 is formed. A first layer 3 is provided on the inner side of the small coil C, and a second layer 4 is provided on the outer side thereof. Arbitrary number of layers are formed, and proper number of conductive layers 5, 5, ···, 5 made of f ine metal particles and insulating layers 6, 6, ···, 6 made of a resin are alternately stacked in each of the layers. Materials of the conductive layers 5 and the insulating layers 6 are inj ected from a conductive material injection port 7 and an insulating material injection port 8 of the ink jet printing technique. The layers 3 and 4 are connected in a proper position, an in-lead 9 connected to another circuit pattern is formed on the bottom of the first layer 3, and an out-lead 10 is formed on the bottom of the second layer 4 (refer to FIG. 4). The first and second layers 3 and 4 can be connected to each other in an arbitrary position. In FIG. 1, the first and second layers 3 and 4 are connected by connecting the conductive layers 5 and 6 forming the uppermost pattern in a connection part 11 (refer to FIG. 7). In this case, the portion between the first layer 3 and the second layer 4 is filled with an insulating material 12, and the connection part 11 is formed on the insulating material 12. For example, the diameter of the first layer 3 is 100 µm, the width of the conductive layer 5 is 10 µm, the second layer 4 is apart from the outer side of the first layer 3 by 10 µm, and the width of the conductive layer 5 of the second layer 4 is also 10 µm. Each of the conductive layer 5 and the insulating layer 6 is formed to a thickness of 10 µm per inj ection. For example, in the case of forming a coil of 50 turns, the thickness of the coil as a whole is 1 mm.

The case of forming a small coil in a circuit pattern will now be described in detail.

In FIG. 2, the insulating film 2 is formed on the substrate 1, and a first turn 13 having a circular shape of the first layer 3 of the coil is injected onto the insulating film 2. The inside diameter φ of the first layer 13 is about 100 µm, and the width W of the first layer 13 is about 10 µm. A lead 9 is formed from a base end 13a of the first turn 13, and is terminated at a circular connection part 14 to another circuit. After that, the first turn 13 of the conductive layer of the first layer 3 is burnt and dried. The front end 13b of the first turn 13 and the base end 13a facing the front end 13b are apart from each other by a predetermined length.

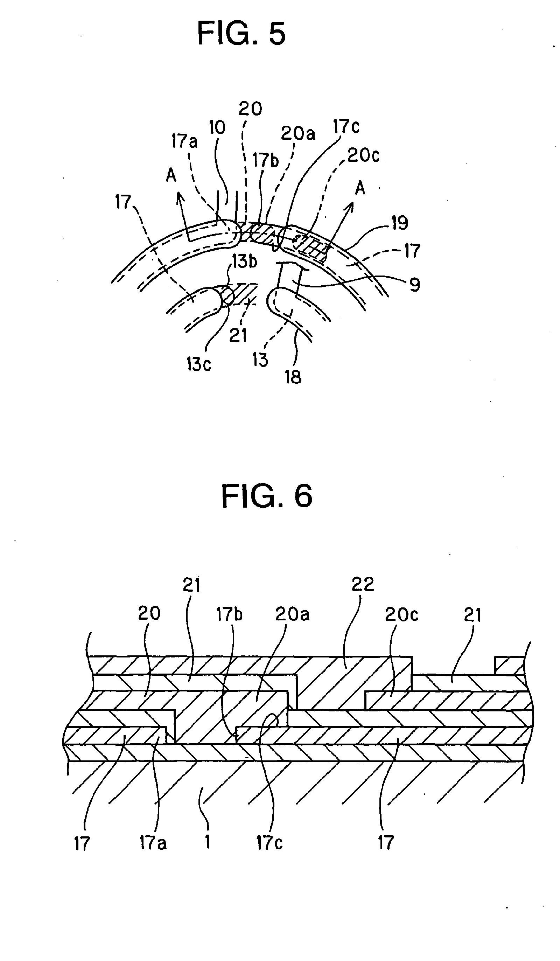

As shown in FIGS. 3 and 4, a circular-shaped insulating layer 16 made of resin for forming the first turn 15 of the second layer 4 is formed so as to cross a base end 9a of the lead (in-lead) 9 of the first layer on the outside of the first turn 13 so as to be apart from the first turn 13 by about 10 µm. A first turn 17 is formed on the insulating layer 16, and the lead (out-lead) 10 extends from a base end 17a of the first turn 17, and is terminated at a connection part 28 to another circuit. The base end 17a of the first turn 17 of the second layer 4 and a front end 17b facing the base end 17a are apart from each other only by a predetermined interval. After that, the first turn 17 of the second layer 4 is burnt and dried. As described above, each of the first turns 13 and 17 of the first and second layers 3 and 4 is sprayed and fixed and, after that, the second turn of each layer is sprayed on the first turn via an insulating film. While forming exposed parts 13c and 17c by slightly leaving the front ends 13b and 17b of the turns 3 and 4 as shown in FIG. 5, insulating films 18 and 19 are formed. The exposed parts 13c and 17c serve as connection parts between the first turns 13 and 17 and second turns 20 and 21 of the layers. Since the connection parts of both of the layers have almost the same state, the state of the connection part of the second layer will be described with reference to FIG. 6.

A conductive layer of the second turn is formed so that a base end 20a of the second turn 20 is connected to the exposed part 17c of the first turn. Also in the conductive layer of the second turn 20, like the first turn, while forming an exposed part 20c, the insulating layer 21 is formed. Similarly, a third turn 22 is formed. The processes are repeated by predetermined number of times. Specifically, the processes of application of the conductive layer (conductive ink), baking and drying, application of the insulating layer, and baking and drying are repeated for each layer by predetermined number of times. At this time, the conductive layers, or insulating layers of the turns of the first and second layers may be simultaneously injected and applied. Alternately, the turns and the insulating layer of the first layer 3 are formed and, after that, the turns and the insulating layer of the second layer 4 may be formed.

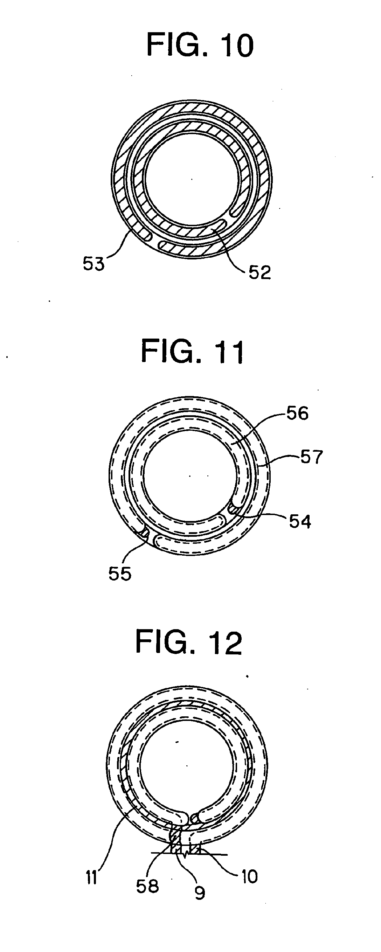

The first layer 3 and the second layer 4 can be connected to each other at an arbitrary turn. For example, as shown in FIG. 7, the base ends of arbitrary turns can be connected to each other. FIG. 8 shows conductive layers of N-th turns of the first and second layers 3 and 4. Insulating layers 50 and 51 are formed on the N-th turns except for exposed portions 40 and 41 as shown in FIG. 9. On the insulating layers, as shown in FIG. 10, conductive layers 52 and 53 of the N+1th turn are formed. On the conductive layer 52 and 53 except for the tips as exposed portions 54 and 55, insulating layers 56 and 57 are formed (FIG. 11). As shown in FIG. 12, an intermediate portion between the layers 3 and 4 may be filled with the insulating material 11. An in-lead and an out-lead can be formed arbitrarily, and a conductive film 58 may be led from the high turn, extended along the outer wall of the insulating layer, and connected to the in-lead 9.

The coil layer can be selected according to the purpose. The coil shape is not limited to the circular shape, but other shape such as a rectangular shape can be freely selected in accordance with design purpose.

Although the turns are stacked on a plane substrate in the embodiment, in the case of manufacturing a very small bobbin, by alternately repeating a conductive layer forming process and an insulating layer forming process directly on the bobbin, a coil having a bobbin can be also manufactured.

The capacitance of the coil can be increased by increasing the width of a conductive pattern or by increasing the thickness by repeating the conductive layer forming process by a plurality of times (N times). Specifically, by repeating the manufacturing process constructed by N times of the conductive layer process, the insulating layer process, N times of the conductive layer process, and the insulating layer process, conductive parts of the N times can be stacked. Thus, a coil having a desired increased conductive capacitance can be manufactured. Naturally, the insulating layer having desired thickness can be also obtained by repeating the insulating process for a desired number of times.

It should be understood that various alternatives to the embodiments of the invention described herein may be employed in practicing the invention. Thus, it is intended that the following claims define the scope of the invention and that methods and structures within the scope of these claims and their equivalents be covered thereby.

## Claims

1. A small coil **characterized in that** it comprises:
a first conductive layer (5) formed as a first turn of a coil by injecting a fine conductive material onto a substrate (1);
a first insulating layer (5) made of an insulating material inj ected onto the first conductive layer (5) while a part of the first conductive layer (5) is exposed; and
a second conductive layer (5) similarly formed as a second turn of the coil on the first insulating layer (6),
wherein said second conductive layer (5) is connected to the exposed part of said first conductive layer (5) and, in such a manner, conductive layers (5) and insulating layers (6) are sequentially alternately stacked.

2. The small coil according to claim 1, wherein the exposed part of said first conductive layer (5) is formed at a front end of said first conductive layer (5), and is connected to a base end of said second conductive layer (5).

3. The small coil according to claim 1, wherein said conductive layer (5) has a cylindrical shape or a prism shape.

4. A method of manufacturing a small coil **characterized in that** it comprises the processes of:
forming a first conductive layer (5) as a first turn of a coil by injecting mixed ink obtained by mixing a fine conductive material from an injection nozzle to a solvent onto a substrate (1);
forming an insulating layer (6) by injecting mixed ink obtained by mixing an insulating material to a solvent onto the first conductive layer (5) in a state where a part of the first conductive layer (5) is exposed;
forming a second conductive layer (5) as a second turn of the coil on the insulating layer; and
sequentially alternately stacking conductive layer patterns and insulating layers while connecting the exposed part of the first conductive layer (5) and the second conductive layer (5) to each other.

5. The method of manufacturing a small coil according to claim 4, wherein the exposed part of said first conductive layer (5) is formed at a front end of said first conductive layer (5), and is connected to a base end of said second conductive layer (5).

6. The method of manufacturing a small coil according to claim 4, wherein said injection nozzle is an injection nozzle used for an ink jet printing method.
